Europäisches Patentamt

European Patent Office

Office européen des brevets

(11) Publication number: **0 184 585**
**B1**

## EUROPEAN PATENT SPECIFICATION

(45) Date of publication of patent specification: **18.10.89**

(21) Application number: **84113590.8**

(22) Date of filing: **10.11.84**

(51) Int. Cl.⁴: **H 03 M 1/60,** H 03 M 3/02,
G 01 V 1/18, G 01 D 5/243,
G 01 H 9/00, H 03 H 9/38

(54) Methods and apparatus for analog to digital conversion.

(43) Date of publication of application:
**18.06.86 Bulletin 86/25**

(45) Publication of the grant of the patent:
**18.10.89 Bulletin 89/42**

(84) Designated Contracting States:
**DE FR GB IT**

(56) References cited:
DE-A-1 938 597
DE-A-2 916 103
US-A-2 985 018
US-A-3 140 612
US-A-3 151 487
US-A-3 185 942
US-A-3 274 497
US-A-3 623 072
US-A-3 896 299
US-A-4 057 796

ELECTRONICS LETTERS, vol. 20, no. 1, January
5, 1984, pp. 39-41, London, GB, N. CHUBACHI
et al.: "New variable acoustic delay line in VHF
range employing a wedge"

(73) Proprietor: **Timeback Systems, Inc.**
**13740 Midway Road Suite 714**
**Dallas Texas 75244 (US)**

(72) Inventor: **Nelson, Robert G.**
**8142 Garland Road**
**Carrollton Texas 75218 (US)**

(74) Representative: **Patentanwälte Kohler -**
**Schwindling - Späth**
**Hohentwielstrasse 41**
**D-7000 Stuttgart 1 (DE)**

Courier Press, Leamington Spa, England.

EP 0 184 585 B1

## Description

Background of the invention
1. Field of the invention

This invention relates generally to methods and apparatus for analog to digital conversion and more specifically to methods of generating a digital signal representative of an analog value and to an apparatus specially designed for performing this method.

2. Description of prior art

Values which can be measured, (e.g., temperature, voltage, pressure, weight, distance, velocity, capacitance, etc.), are often digitized so that the measure can be expressed as discrete steps or digits. The first step in digitizing often includes the use of a transducer, a device that will convert energy from one form to another. For example, a piezoelectric crystal can be used to convert pressure variations into an analog voltage and a thermistor can be used to generate an analog voltage as a function of temperature. These voltages can then be digitized by an analog-to-digital converter. Other transducers, however, can more directly generate a digital output. For example, an interferometer can convert a displacement into a changing optical interference pattern that can then be converted into a pulsing, and hence digital, voltage by a photocell.

A popular form of analog-to-digital converter utilizes a ladder of matched resistors to divide either the input voltage or a reference voltage into a series of levels and arrive at a digitized or quantized representation of that voltage. When used in these devices, feedback is in the form of a voltage.

Voltage-to-frequency converters have a frequency output which is continuously variable. To be more useful, this output can be counted by a binary counter gated by a fixed clock or the output can be used to gate a fixed clock being used to drive a counter. Voltage-to-time converters, such as integrators, can be used in a similar manner as a substitute for the voltage-to-frequency converters.

A third form of converter is the delta-modulator which generates a single weighed digital pulse train with the polarity of the pulses dependent on a difference signal. This difference signal is created by subtracting the input voltage from a feedback voltage. The feedback voltage is generated by either a charge dispensing circuit or a digital-to-analog converter.

Summary of the invention

In accordance with the present invention, there is provided a method of generating a digital signal representative of an analog value in which with two generating means, each independent of the other, two highfrequency digital pulse signals are generated, the frequencies of which are constant and harmonically related one to the other. A sample of the analog value is applied to at least one of said generation means to cause a shift in phase in at least one of the said highfrequency digital pulse signals. The digital pulse signals are then compared to obtain a measure signal of the phase shift, which is utilized to adjust the phase of the highfrequency digital pulse signals toward an in-phase condition. As a result of the measure of phase shift, there is generated a further digital signal which is representative of the amplitude of the said measure signal utilized to return said highfrequency digital pulse signals toward the in-phase condition. The digital signal may be a single weighed digital signal and may further be applied to a lowpass digital filter to produce a multi-bit digital word representative of the instantaneous analog value.

In another embodiment of the invention, the analog value is applied to effect a shift in phase of both digital signals, and the measure signal representing phase shift is utilized to introduce a delay in one of the phase shifted highfrequency digital pulse signals which is in advance of the other.

An apparatus specifically designed for performing the method of the present invention comprises:

a) two means for generating highfrequency digital pulse signals whose frequencies are constant and harmonically related one to the other, each said generating means comprising an oscillator;

b) means responsive to a sample of said analog value to effect a relative phase shift between said highfrequency digital pulse signals;

c) means for measuring said relative phase shift and for obtaining a measure signal thereof;

d) means responsive to said measure signal to return said highfrequency digital pulse signals toward an in-phase relationship;

e) means for producing a further digital signal representative of said measure signal; and

f) means for utilizing said digital signal.

In a preferred embodiment of the invention, the means responsive to a sample of said analog value comprises a housing, a mass of fixed dimensions mounted within said housing, the housing and the mass being movable relative to one another in response to an external analog value. An input is provided for receiving digital pulses and means within the housing responds to the appearance of the digital pulses at the input for introducing a phase shift in the digital signals proportional to the relative positions between the housing and the mass.

In accordance with the present invention, the aforesaid apparatus can take the form of a direct digital geophone comprising a casing and a spring mounted element or mass within the casing responsive to earth movement. The spring mounted element or mass has opposite faces with a transducer element mounted on one element. A mating transducer element is mounted on an opposed inside surface of the casing. The transducer element and the mating transducer element form a transducer assembly which is responsive to movement of the spring mounted element to produce signals representative of the instantaneous position of the spring mounted element relative to the casing. In a specific embodiment, the transducer elements comprise a high frequency acoustic transmitter and a high frequency acoustic receiver.

A system embodying the present invention includes two oscillators, a phase comparator, a variable delay element related to the variables to be digitized, a circuit to cause discrete phase shifts, and control circuitry, from each cycle of the oscillators, the phase comparator determines which oscillator is leading. The external variable affects the variable delay and thus the oscillators phase relationship. The control circuitry utilizes the phase comparator's output to control the discrete phase shifting circuit to bring the two oscillators back toward an in-phase relationship. The phase adjustments made with the discrete phase shifting circuit are encoded in a single weighed digital pulse train which may be applied to a digital low-pass filter to generate a multiple-bit binary word at a lower data rate, or it can be processed by an analog low-pass filter to construct an analog representation of the original variable. In a preferred method for implementing the invention, one or both of the aforesaid oscillators are implemented by way of a loop comprised of one or more delays cascaded together to provide a path and regeneration for one or more energy events continuously circulating in the loop. The energy event can be an electrical transition or pulse, an acoustic pulse, or an optical pulse. The combination of the energy events and the loop which recirculates and sustains the energy events constitutes an oscillator. When two energy events are recirculating in one loop, two oscillators coexist within that one loop as long as the energy events are separated in phase around the loop. A circuit is utilized to cause discrete phase shifts to one or both of the oscillators to cancel out the variable caused phase shifts as seen by the phase comparator. These discrete phase corrections occur once every loop or oscillator cycle so that the oscillators, as seen by the phase comparator, stay less than two discrete phase shifts of each other.

The advantages of the present invention can be understood from the following description of several techniques of practicing the invention described in conjunction with the following drawings.

Brief description of the drawings

Fig. 1 is a schematic diagram of a time interval digitizer embodying features of the present invention.

Figs. 1A and 1B are waveform timing diagrams helpful in understanding of the general operation of the embodiment of Fig. 1;

Figs. 2A and 2B are more detailed waveform timing diagrams helpful in gaining an understanding of the detailed operation of the embodiment of Fig. 1;

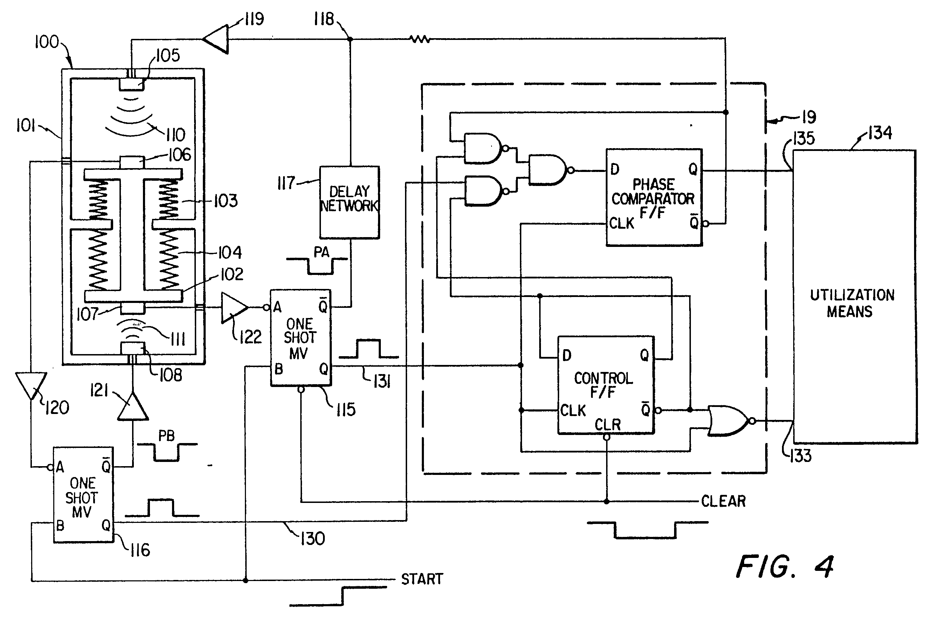

. Fig. 3 is a significantly enlarged representation of the trailing edge of a pulse representing the logic levels thereof utilized in effecting discrete phase shifts in the practice of the present invention;

Fig. 4 is a schematic diagram of a direct digital geophone shown connected in the circuits which convert the velocity variations of the phone components to a direct digital signal;

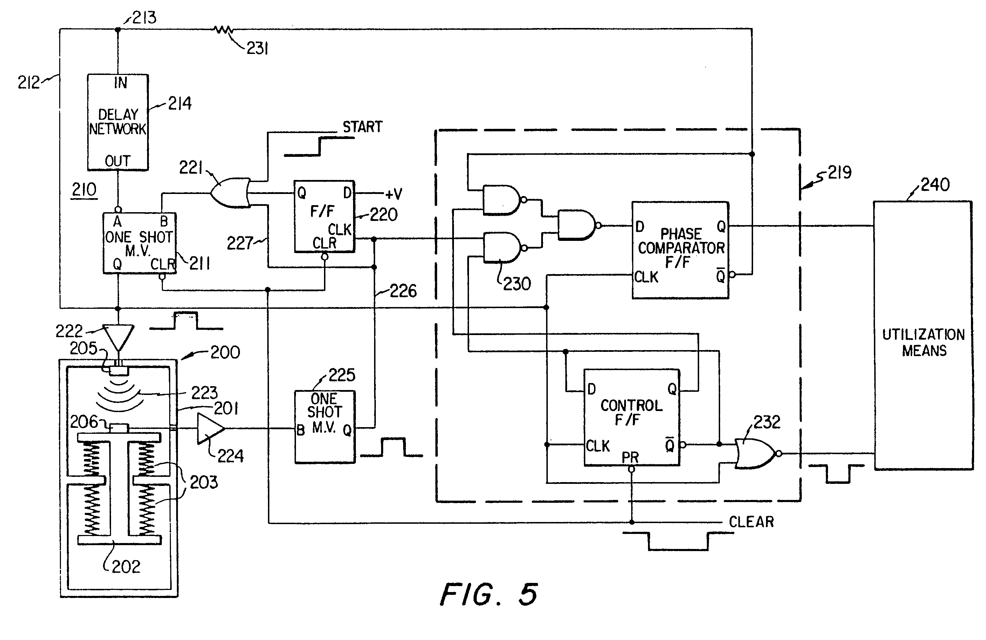

Fig. 5 is another species of the invention incorporating a modified direct digital geophone together with the logic elements for converting variations in velocity of the geophone to digital representations;

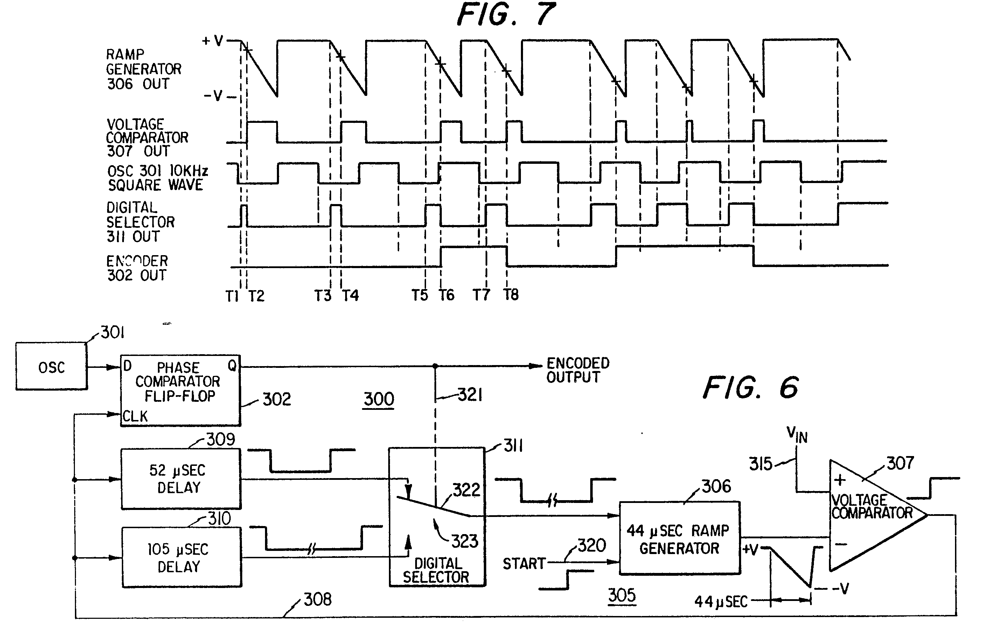

Fig. 6 is a schematic diagram of an analog-to-digital converter embodying features of the present invention; and

Fig. 7 is a pulse timing diagram helpful in the understanding of the operation of the embodiment of Fig. 6.

Detailed description
Time interval digitizer

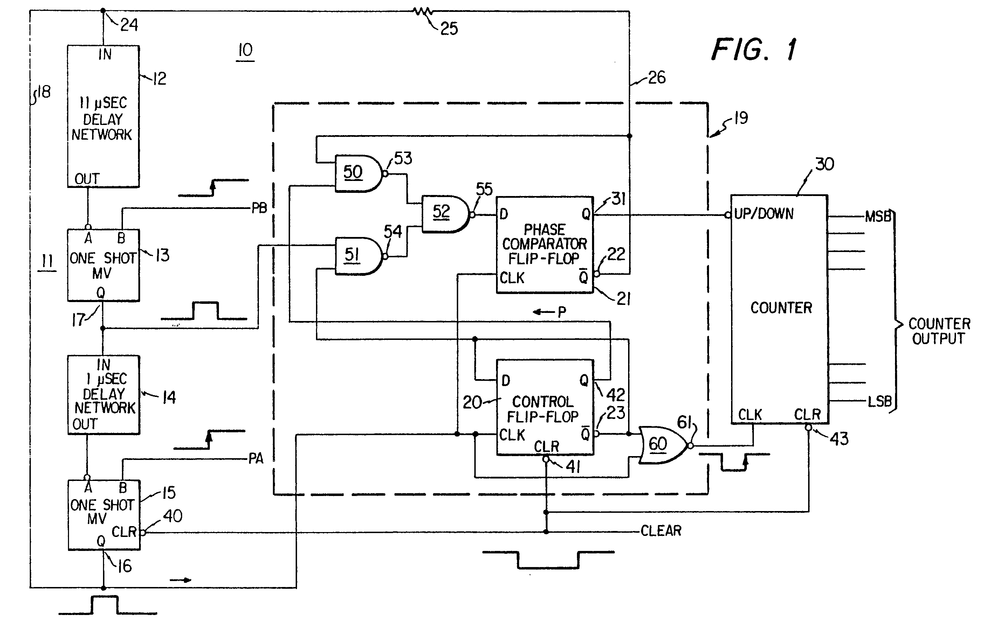

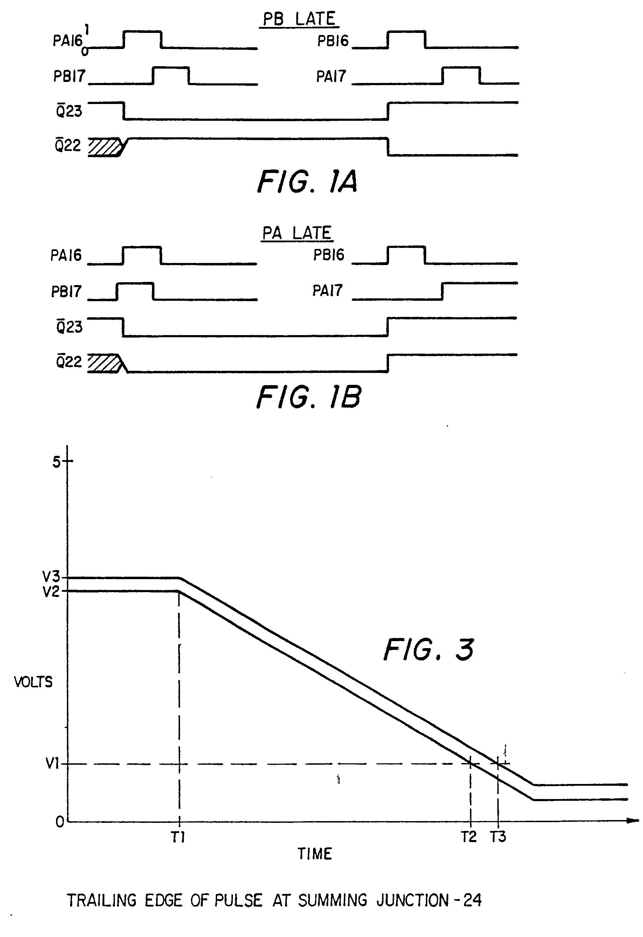

Fig. 1 is a schematic representation of a time interval digitizer 10 embodying features of the present invention. A time interval digitizer is useful in quantizing the time separation between two external events such as the time occurrence of a pulse and the arrival of the pulse at a receiving station. Common with all species and repesentations of the invention is the presence of two oscillators which generate two high-frequency digital signals. The frequency of each signal is constant and the frequencies are harmonically related one to the other. In the embodiment of Fig. 1 the frequencies are equal. Due to the effects of an analog condition, a phase shift will occur or exist as between the high-frequency digital signals. The phase shift is determined by comparing the signals to obtain a measure of that phase shift, and the measure of phase shift is utilized to adjust the phase of one of the signals to bring it toward an in-phase relationship with the other signals. The phase shifts are discrete and represent an adjustment being made in the return of one signal toward an in-phase relationship with the other signal. From the adjustment being made, there is produced a single weighed digital function which represents the amplitude of the adjustment necessary to bring the two signals toward an in-phase relationship and thus representative of the time difference or phase difference that existed prior to the phase adjustment.

In Fig. 1, the two oscillators are provided by a loop 11 which includes four delay elements, the delay networks 12 and 14 and the active delay elements 13 and 15 which are in the illustrated embodiment comprised of one-shot multivibrators. Now upon the application of a pulse PA to the B input of the one-shot multivibrator 15, there will be produced at the output 16 of the multivibrator a short duration pulse which will circulate by way of conductor 18 and summing junction 24 to an input of the delay network 12 and thence to the inverted input A of the multivibrator 13. The multivibrator is triggered to reproduce pulse PA which proceeds through the delay network 14, and thence to the inverted input A of the multivibrator 15. The multivibrator is triggered to reproduce pulse PA at its Q output 16. It is apparent that the initial pulse PA will now effectively continue to circulate in the loop 11 indefinitely and thus constitutes in every respect a first oscillator.

Upon the injection of a second pulse PB to the B input of the one-shot multivibrator 13, a representation of the onset of the pulse PB will continuously circulate or propagate in the loop 11 in a manner similar to the above-described propagation of pulse PA and thus in every respect will constitute a second oscillator. The two pulses PA and PB will continue to propagate or circulate around the loop in spaced time relation and maintain their original phase relationship absent any outside effects.

The delay networks 12 and 14 can be any of a variety of pulse delay networks known in the art such as lengths of cable, cascaded one-shot multivibrators or cascaded inductor-capacitor networks, or combinations thereof. In the species of Fig. 1, the delay network 12 induces a delay of 11 microseconds and the delay network 14 introduces a delay of one microsecond. The two one-shot multivibrators 13 and 15 each generate a pulse and provide a delay of 0.25 microseconds. Accordingly, in this specific embodiment the total time for each of the pulses to travel around the loop is 12.5 microseconds. It will be understood that the foregoing time delays are merely given as exemplary values, and that other values may be utilized in the practice of the present invention.

In the example given, there is to be determined the time separation between the appearance of the pulses PA and PB at their respective reference points. The reference points for the pulse PA is the Q output 16 of the multivibrator 15. The reference point for the pulse PB is the Q output 17 of the multivibrator 13. With the above-described values of the delay networks and the pulse duration of the one-shot multivibrators, the occurrence of pulse PB is constrained to occur at the same time or within ten microseconds after the occurrence of PA.

The positive going edge of pulse PA triggers the one-shot multivibrator 15 which generates a 0.25 microsecond positive pulse at its Q output 16 illustrated as PA 16 in Fig. 1A. This pulse now propagates through the delay network 12 for 11 microseconds and the negative going edge of its output triggers the one-shot multivibrator 13. The one-shot multivibrator 13 generates a 0.25 microsecond positive pulse at its output 17 which then propagates through the delay network 14 for one microsecond. The negative going edge of the pulse now triggers the one-shot multivibrator 15 to generate another 0.25 microsecond pulse which will again propagate through the delay network 12 as above described. Thus, after being inserted into the loop, pulse PA or its equivalent propagates around the loop every 12.5 microseconds. This pulse PA circulating around the loop is equivalent to one oscillator.

The second event represented by the occurrence of pulse PB occurs at the same time as or within 10 microseconds after the time occurrence of the pulse PA. The positive going edge of the pulse PB triggers the one-shot multivibrator 13 to generate a 0.25 microsecond pulse at its Q output 17. The time occurrence of this pulse is illustrated in Fig. 1A as the pulse PB 17. The pulse now propagates through the delay network 14 and continues to propagate around the same loop in the same manner as pulse PA. The pulse PB circulating around the loop is equivalent to the second oscillator. It will be noted that pulse PB was introduced into the loop before the pulse PA had time to propagate to the one-shot multivibrator 13 for the first time. Thus, pulses PA and PB propagate similarly around the loop except that they are displaced in phase or time.

The time occurrence of the pulses at the output 17 of the one-shot multivibrator 13 and at the output 16 of the one-shot multivibrator 15 will be effective in controlling the operation of the control 20 and a phase comparator 21, included in logic network 19, so as to determine the logic level of the $\overline{Q}$ output 22 of the phase comparator 21. The control 20 and the phase comparator 21 are flipflops. The logic at the $\overline{Q}$ output 22 is applied by way of conductor 26 and high impedance 25 to the summing junction 24 selectively to introduce delays in the leading one of the pulses PA or PB and such delays will continue in discrete fashion until the pulses are returned toward an in-phase relationship to within about one discrete phase delay of one another as seen by the logic network 19.

As illustrated in Fig. 1A, the pulse PA 16 leads the pulse PB 17 in accordance with the preliminary or initial conditions established for description of the logic operation of the system. The logic level at the $\overline{Q}$ output 23 of the control 20 drops to a O logic level upon the occurrence of the pulse PA 16 while the logic level, previously unknown, at the $\overline{Q}$ output 22 of the phase comparator (shown as the shaded area) rises to the 1 logic level. At the 1 logic level, there will be a delay introduced to the pulse PA at the summing junction 24 by modifying the trailing edge of the pulse PA. Now upon the occurrence of the pulse PB at the output 16 of the one-shot multivibrator 15; the $\overline{Q}$ output at 23 of the control 20 will rise to the 1 logic level and cause the logic level at the $\overline{Q}$ output 22 of the phase comparator 21 to fall to a 0 logic level whereupon the pulse PB upon its arrival at the summing junction 24 will be unaffected or otherwise stated, there will be no delay introduced to the pulse PB. The operation will continue until both pulses are effectively brought into phase, that is when the pulse PA and PB appear at the same time or within one discrete phase delay at their respective reference points in the loop 11.

Each time the phase comparator output $\overline{Q}$ at 22

rises to *1* logic level representing a discrete delay applied to pulse PA, the counter 30 is triggered to count that occurrence of the *1* logic level. The counter will stop counting when the pulses are in phase. The output of the counter will be representative of the number of discrete time delays introduced in order to bring the pulses back into phase and therefore also representative of the initial phase difference or time difference as between the occurrence of pulses PA and PB.

When the system introduces sufficient increments of delay to the pulse PA to bring the pulse PA and PB to within one delay increment, the system will then continue to introduce an incremental delay to pulse PA such that pulse PB will now lead. In this sense, the system will overcompensate but then logic to hunt or "toggle" back and forth producing in accordance with the logic circuitry alternate logic *1*'s and logic *0*'s to the counter 30, causing the counter to count up and down and thus effectively maintaining a readout representative of the inital time difference between the occurrence of the pulses PA and PB. In this foregoing situation where the pulse PB now leads pulse PA, the following operation of the system takes place.

The time occurrence of the lead pulse PB at output 17, as represented by the pulse PB 17 of Fig. 1B, conditions the logic of the system of Fig. 1 such that upon the occurrence of the pulse PA at output 16, represented by the pulse PA 16 (Fig. 1B), causes the $\overline{Q}$ output at 22 of the phase comparator 21 to fall to a *0* logic level. Pulse PA 16 will also cause the $\overline{Q}$ output at 23 of the control 20 to fall to a *0* logic level. Accordingly, the pulse PA, upon its appearance at the summing junction 24, is unaffected. In other words, there is no delay introduced to pulse PA. However, when the pulse PB arrives at the output 16 of the one-shot multivibrator 15, it causes the logic level at the $\overline{Q}$ output 23 of the control 20 to rise to the *1* level and also clocks the phase comparator 21 to cause the logic level at the $\overline{Q}$ output 22 to rise to the *1* level, thereby introducing a delay to the pulse PB. The operation continues with the system hunting about the in phase relationship as between pulses PA and PB.

The discrete delays are effected by causing the voltage at summing junction 24 to rise and fall as between the two logic levels of *0* and *1*. The affect of the change in voltage levels is illustrated in Fig. 3 which represents an enlarged representation of the trailing edge of a pulse occuring at the juncture 24. The pulse may be either the pulse PA or the pulse PB.

The one-shot multivibrator 13 is conditioned to trigger when the trailing edge of a pulse appearing at its inverted A input drops to a voltage level of $V_1$. Since the slope of the trailing edge of the pulse is a constant, the time it will take for the trailing edge to drop to the value of $V_1$ is a function of the voltage value of the pulse at time $T_1$. Under a condition of no delay, the voltage level of the trailing edge of the pulse at $T_1$ is $V_2$ and will fall to a trigger value of $V_1$ at time $T_2$.

However, when the logic at the $\overline{Q}$ output 22 of the phase comparator raises to a *1* level the voltage of the pulse at the summing junction 24 rises to a value $V_3$, begins falling at time $T_1$ and reaches the triggering value $V_1$ for the one-shot multivibrator L3 at time $T_3$. Accordingly, each time the logic level at the summing junction 24 reaches a *1* level, a delay of approximately $T_3$ minus $T_2$ will be introduced to the affected pulse. The time difference of $T_3$ minus $T_2$ represents the discrete phase shifts introduced each time the pulses make one trip around the loop.

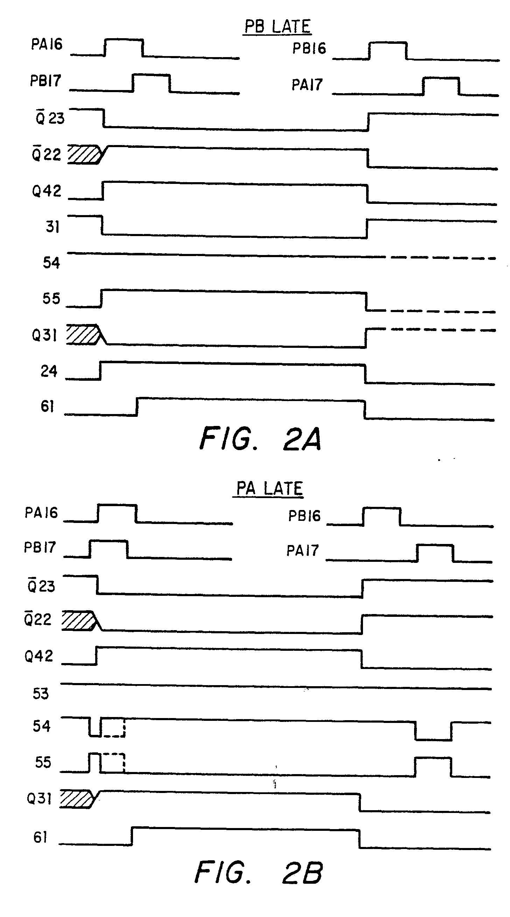

There will now be described a detailed description of the embodiment of Fig. 1. In the following description, reference will be made to the waveform timing diagrams of Figs. 2A and 2B. The system is initialized by a CLEAR pulse from a source not shown. Because the total delay in loop 11 is 12.5 microseconds, the CLEAR pulse is held low for at least 12.5 microseconds and is applied to the CLR input 40 of the one-shot multivibrator 15 to prevent all existing pulses in the loop from being regenerated. The CLEAR pulse also is applied to the CLR input of the control flipflop 20 and the counter 30. The application of CLEAR to the CLR input 41 of the control flipflop 20 sets the flipflop to have a *0* logic level at its Q output 42 and a *1* logic level at the $\overline{Q}$ output 23. The application of CLEAR to the CLR input 43 of the counter 30 resets the counter. The two events, pulses PA and PB, whose time separation is to be measured are produced by circuitry not shown. Pulse PA is the first to occur. As previously described, the pulses PA and PB propagate around the loop 11 and represent two oscillators.

The control flipflop 20 has its $\overline{Q}$ output 23 coupled or fed back to its D input while the phase comparator flipflop 21 has its $\overline{Q}$ output at 22 fed back to its D input by way of logic network comprised of three NAND gates 50, 51, and 52. Thus, whatever state the control flipflop 20 is in, it will be reversed whenever a pulse is applied to its clock input CLK. However, because the coupling of the $\overline{Q}$ output at 22 of the phase comparator flipflop 21 to the D input is by way of the logic network, the state of the phase comparator 21 will be determined by whether pulse PA is leading and continues to lead pulse PB.

Regardless of the initial state of the phase comparator flipflop 21, a *0* logic is applied to its D input immediately upon the application of the CLEAR pulse and for the following reasons. Prior to the application of the pulses PA and PB, a *0* logic level appears at and is applied from the output 17 of the multivibrator 13 to one input of the NAND gate 51 and a *1* logic level is applied to the other input of the NAND gate 51 from the $\overline{Q}$ output 23 of the control flipflop 20. Accordingly, the output of the NAND gate 51 at 54 is a logic *1*. *0* logic is applied to one input of the NAND gate 50 from the Q output 42 of the control flipflop 20. That being the case, no matter what the logic level is at the $\overline{Q}$ output 22 of the phase comparator flipflop 21, the output of the NAND gate 50 will be a logic *1*. Accordingly, with logic *1* levels applied to both inputs of the NAND gate 52, the output at 55 will be a logic 0. Now upon the application of the pulse PA to the one-shot multivibrator 15, there will appear at its output 16 a pulse PA 16 as shown in Fig. 1, which will clock the control flipflop 20 and the phase comparator flipflop 21. As shown in Fig. 2A, the logic level at the $\overline{Q}$ output 23 will drop to a logic 0 while the $\overline{Q}$ output of the phase comparator at 22 will be established at a 1 level. Similarly, the logic level at the Q output at 42 of the control flipflop 20 will rise to a 1 level and the logic level at the Q output 31 of the phase comparator flipflop 21 will drop to a 0 level. The logic level at the $\overline{Q}$ output 22 of the phase comparator 21 is fed back to one input of the NAND gate 50 and that 1 logic level appears at the output 55 of the NAND gate 52 and is applied to the D input of the phase comparator 21.

With a 1 logic level established at the $\overline{Q}$ output 22 of the phase comparator 21, the voltage level at summing junction 24 is raised to introduce a discrete phase or time delay to the pulse PA. Further, with the logic level at Q output 31 of the phase comparator dropped to 0 and applied to the inverted input up/down of the counter 30, the counter is instructed to count up upon receipt of the next clock pulse.

The clock pulse is applied by way of NOR gate 60, which has applied to one input the $\overline{Q}$ output 23 of the control flipflop 20 and to another input, the output of the one-shot multivibrator 15. Thus, with 0 logic level applied from the $\overline{Q}$ output of the control flipflop 20 to one input of the NOR gate 16, then upon the occurrence of the trailing edge of the pulse PA at output 16 of the one-shot multivibrator 15, the NOR gate has at its output 61 a level of logic 1 as shown in Fig. 2A, and this logic level is applied to the clock input of the counter 30. The counter then counts up 1, indicating one discrete time delay being introduced to the pulse PA.

When the pulse PB appears at the output 16 of the multivibrator 15, it triggers or toggles the phase comparator flipflop 21 and the control flipflop 20. The triggering of the phase comparator 21 causes its $\overline{Q}$ output at 22 to drop to a 0 logic level, which is then applied by way of impedance 25 to the summing junction 24, and as a result, the pulse PB passes the summing junction 24 and into the delay network 12 without any change or modification to its trailing edge. It then triggers the one-shot multivibrator 13 at time $T_2$ as shown in Fig. 3.

The operation continues with the logic levels at the D inputs of the phase comparator 21 and the control flipflop 20 toggling from one value to the other, and the $\overline{Q}$ output 22 of the phase comparator flipflop being raised to a 1 logic level each time the pulse PA appears at output 16 of the one-shot multivibrator 15. When the pulse PA arrives at its reference point 16 at the same time or within one discrete phase delay of the arrival of the pulse PB at its reference point 17, the pulses will be in phase.

Then the pulses are substantially or effectively in phase, the system will overcompensate and hunt about the 0 phase relationship, as seen by the logic network 19, established between the pulse PA and the pulse PB.

The situation that exists in the hunting process when the pulse PB now arrives at its reference point 17 before the pulse PA arrives at its reference point 16 is illustrated in Fig. 2B. The appearance of the pulse PB at reference point 17 establishes a 1 logic level at an input of the NAND gate 51 at a time when the logic level at the other input of that NAND gate is a logic 1. Accordingly, the logic level at the output 54 of the NAND gate 51 becomes a logic 0 and with a logic 1 appearing at the output 53 of the NAND gate 50, the logic level at the output 55 of the NAND gate 52 becomes a logic 1. Upon occurrence of the leading edge of the pulse PA at reference point 16, the control flipflop 20 and the phase comparator flipflop 21 are clocked or triggered and the logic level at the $\overline{Q}$ output 22 of the phase comparator drops to a logic 0. Accordingly, upon the appearance of the pulse PA at the summing junction 24, the pulse trailing edge is unaffected and hence a delay is not introduced to the pulse PA. At the same time, the logic level at the Q output 31 of the phase comparator goes to 1 instructing the counter to count down on the occurrence of the trailing pulse PA at reference pulse 16. The NOR gate 60 has a logic 1 at its output 61 to clock the counter and causes the counter to count down one delay increment.

Now upon the appearance of pulse PB at reference point 16, the control flipflop 20 and the phase comparator flipflop are clocked or triggered, and the output of the $\overline{Q}$ output at 22 of the phase comparator rises to the logic 1 level which will introduce a delay to the pulse PB upon its appearance at the summing junction 24. The delay will be sufficient enough so that pulse PA will arrive at its reference point 16 before the pulse PB arrives at its reference point 17 causing the $\overline{Q}$ output 22 at the phase comparator control flipflop 21 to rise to a logic 1 which, as shown in Fig. 2A, will cause the system to introduce a delay now to the pulse PA and condition the counter 30 to count up one. The delay is sufficient again to cause the pulse PA to arrive at its reference point 16 after the pulse PB arrives at its reference point 17 and the system continues as above described to hunt within one discrete phase delay and effectively cause the counter 30, for all practical purposes, to stop counting.

The total count measured at the output of the counter 30 after the counting has stopped is equivalent to the number of discrete phase shifts or delays necessary to delay PA until the two pulses come within one discrete phase shift of each other, as seen at their respective loop reference points, 17 for PB and 16 for PA. Thus the total count multiplied by the time value of the discrete phase delay, $T_3$ minus $T_2$, equals the initial time difference between the PA and PB and the external events that they represent.

## Velocity digitizer—MOD 1

Having described in detail the principles of the invention wherein two oscillators are employed together with logic circuitry to produce a direct digital representation of the phase or time displacement between two pulses, there will now be undertaken the description of an application of these principles to a velocity digitizer. The invention is generally applicable for use in digitizing the velocity or phase of any time varying function. The function may be the relative movement between any two objects. More specifically, embodying relative moving objects or mechanical parts would include such apparatus as ribbon microphones, geophones and similar instruments. In Fig. 4, there is illustrated the application of the present invention with a new and improved geophone 100.

Prior art geophones typically utilize or are comprised of a case or casing, a spring supported mass within the casing, and a coil. The geophone, when coupled to the earth, is responsive to earth movements which cause a relative displacement between the mass and the casing to generate with the coil an electrical analog signal which, in accordance with today's procedures, is digitized and recorded for data processing purposes. The prior art geophone has two severe drawbacks. One of these is the susceptibility to noise such as stray 60-cycle fields which are picked up by the coil. This noise is removed by the utilization of notch filters which tend to distort the signal or frequency content of the signal, in that notch filters will not only attenuate the unwanted 60 cycle signal, but also frequency components lying on either side of the 60-cycle component. In addition, the prior art geophones have limited dynamic range.

The new and improved geophone in accordance with the present invention avoids the undesirable characteristics of the prior art geophones in that it is non-responsive to stray electromagnetic fields, hence not requiring the use of notch filters, and furthermore provides a direct digital output of significantly increased dynamic range. More specifically, the geophone 100 is comprised of a case or casing 101 having mounted therein a mass 102, supported by resilient means such as springs 103 and 104. Within the casing 101 are means responsive to the appearance of pulses to introduce phase shifts to the pulses proportional to the instantaneous relative positions between the casing and the mass, and therefore representative of the relative velocity between the casing and the mass. The means are circuit elements with one of the elements being mounted on an inner surface of the casing and the other of the elements being mounted on the mass so that the phase shift is introduced by relative movement between the elements. As shown in the specific embodiment of Fig. 4, the elements include transmitter 105 mounted to the inner surface of the casing 101 and a receiver 106 mounted to an upper surface of the mass 102. In this embodiment, a second set of circuit elements is employed including the transmitter 108 mounted to an inner surface of the casing 101 and a receiver 107 mounted to a lower surface of the mass 102.

The geophone 100 is in a loop through which pulses PA and PB circulate. The circulation of the pulses around the loop effectively provides two oscillators.

The pulses PA and PB are respectively and simultaneously generated by one-shot multivibrators 115 and 116. Pulse PA, appearing initially at the $\overline{Q}$ output of the multivibrator 115, propagates by way of delay network 117 and summing junction 118 to the input of digital amplifier 119. There the pulse PA is amplified and applied to excite the piezoelectric transducer or transmitter 105 which now generates an acoustic pulse. The acoustic pulse travels, as shown at 110, by way of the air space within the casing 101 to the piezoelectric transducer or receiver 106. The resulting pulse at the output of the piezoelectric transducer 106 is applied to amplifier 120, and the amplified output propagates to the inverted input A of the one-shot multivibrator 116. The multivibator 116 is triggered to produce the negative pulse PA at its $\overline{Q}$ output. This pulse is amplified by the amplifier 121 and applied to excite the piezoelectric transducer or transmitter 108. The resulting acoustic pulse travels, as shown at 111, by way of the air space within the casing 101 to the piezoelectric transducer or receiver 107. The electrical pulse output of the receiver 107 is amplified by the amplifier 122 and appears at the inverted input A of the one-shot multivibrator 115. The appearance of the pulse at the inverted input A of the multivibrator 115 causes the multivibrator to produce at its $\overline{Q}$ output the negative pulse PA and the process continues until interrupted. The circulation of the pulse PA or its equivalent around the loop in the manner described constitutes a first oscillator.

Pulse PB initially appears at the $\overline{Q}$ output of the one-shot multivibrator 116 and thereafter follows a path around the loop as previously described in conjunction with the propagation of the pulse PA. The circulation or propagation of the pulse PB or its equivalent constitutes a second oscillator.

During each loop cycle, both pulses PA and PB travel through the same path. Since the instantaneous path does not vary, the loop frequency of the pulses PA and PB does not vary except due to phase modulation caused by the casing-to-mass relative velocity. Inasmuch as pulses PA and PB are initially separated in phase in the loop, the phase modulation caused to the pulse PB by the motion of the mass 102 will be different from the phase modulation applied to PA. For, example, when the mass 102 is moving in a downward direction, the time for pulse PB to circulate around the loop is increased while the time for the pulse PA to circulate around the loop is decreased. The difference in the loop times between the pulses PA and PB results in a relative phase shift between the pulses and the magnitude of this phase shift is proportional to the relative casing-to-mass velocity.

The system of Fig. 4 further includes the logic arrangement shown enclosed within block 19. This logic arrangement or network 19 is the same as that described above in conjunction with Fig. 1.

The operation of the system of Fig. 4 is begun by initially clearing the loop with a low CLEAR signal applied to the CLR input of multivibrator 115. The time duration of the CLEAR pulse is at least as long as one loop cycle to assure the termination of any pulses then circulating within the loop. The CLEAR signal also sets the control flipflop in the logic network 19. A START pulse is now generated by a source not shown and is applied simultaneously to the B inputs of the multivibrators 115 and 116, thereby simultaneously generating the pulses PA and PB. The Q output, a positive pulse, of the one-shot multivibrator 116 is applied by way of conductor 130 to the NAND network within the logic system 19 and the Q output, a positive pulse, of the one-shot multivibrator 115 is applied by way of conductor 131 to clock the phase comparator flipflop and the control flipflop in the logic network 19.

The pulse PA appearing at the $\overline{Q}$ output of the multvibrator 115 is negative going, and applied initially to the delay network 117. The delay introduced by the network 117 is provided in order to permit time for the phase comparator flipflop output at $\overline{Q}$ to be applied to the summing junction 118 before the leading edge of the pulse PA arrives at the summing junction. The delay is of a small order, for example 50 nanoseconds. The delay network may be provided by transistor-transistor logic.

Since the pulses PA and PB are started in the loop in phase as seen by the logic network 19, the leading edge of the pulse PB at the D input to the phase comparator flipflop will generally not be more than one discrete phase shift from the pulse PA at the flipflop clock inputs CLK.

The relationship between the pulses PA and PB at the logic network 19 and the various logic states within the network will be similar to those illustrated in Figs. 2A and 2B. If the leading edge of the pulse PB occurs at its reference point, the Q output of the multivibrator 116 before the pulse PA appears at its reference point, the Q output of the multivibrator 115, a delay will be applied to the leading edge of the pulse PB at the summing point 118. The delay is caused by the phase comparator flipflop changing state and applying a logic 1 level from its $\overline{Q}$ output to the summing junction 118 to cause a discrete phase shift to the leading edge of the phase PB. On the other hand, when the pulse PB occurs after the pulse PA, as shown in Fig. 2A, then the circuitry will cause a discrete phase shift or delay to the pulse PA.

The delay provided at the summing point 118 is small compared to the total loop time. For example, the magnitude of this delay might be about 1 nanosecond when the loop time is about 10 microseconds. The loop frequency is usually chosen to be at least twice the highest frequency of the velocity to be digitized.

Each time the pulse PA appears at its reference point Q of the multivibrator 115, it is clocked through the logical NOR gate in the logic network 19. The trailing edge of the pulse PA will appear as a positive going edge at the input 133 of the utilization means 134 and is used as a strobe to indicate that the output from the phase comparator flipflop applied to the second input 135 of the utilization means 134 is valid. The input signal to the utilization means at 135 will be a series of 1's and 0's based upon decisions made by the logic network 19. If the mass 101 is moving very quickly in one direction, there will be a series of logic 1's. If the mass is moving quickly in another direction, there will be a series of logic 0's. If the mass 102 is stationary, the output of the logic network 19 will be a series of alternating 1's and 0's. Between the two limits of movement, the signal from the logic network 19 will be comprised of varying sequences of logic 1's and logic 0's.

The utilization means 134 may take any desired form. It can comprise a recorder to which the output from the logic network 19 is applied directly for processing at another site. On the other-hand, the utilization means may comprise a low-pass filter, the output of which will be a multi-bit binary code representing the velocities of the mass 102 relative to the casing 101. The utilization means may also take the form of a D-A convertor in which the output of the logic network 19 is converted to an analog signal and displayed for analysis at the site or recorded for analysis at a remote location.

Velocity digitizer—Mod II

It will be recalled that in the embodiment of a velocity digitizer illustrated in Fig. 4, the device whose velocity was to be digitized, in this case a geophone 100, was located directly in the loop through which the pulses PA and PB were circulating. In the embodiment illustrated in Fig. 5, the device whose velocity is to be measured is located outside the circulating loop and the operation is such that delays are introduced by the device effectively only to one of the pulses.

The device in Fig. 5 is a novel geophone 200 comprised of a case or casing 201 having mounted therein a movable mass 202. The mass 202 is supported for relative movement within the case or casing 201 by a pair of springs 203.

The geophone 200 is different from any geophones of the prior art in that in lieu of a coil used in prior art geophones for generation of an electrical analog signal representative of movement of the mass 202 relative to the case or casing 201, the geophone 200 includes non-inductive circuit elements mounted respectively to the inside surface of the case 201 and to a surface of the mass 202. More specifically, the circuit elements are shown as transducers including a transmitting transducer 205 mounted to the inside surface of the case 201 and a receiving transducer 206 mounted to the upper surface of the mass 202. Whereas the geophone 100 of Fig. 4 includes two pairs of circuit elements or transducers, the geophone 200 of Fig. 5 includes but one pair.

The embodiment of Fig. 5 incldues a loop 210 through which pulses PA and PB will circulate. The pulses will propagate from the Q output of the one-shot multivibrnator 211, thence by way of conductor 212, summing junction 213, delay network 214, and back to the inverted input A of the one-shot multivibrator 211. The circulation of the pulses PA and PB will provide the two oscillators which are the principal elements of the present invention.

In this embodiment, pulse PA will serve as a reference, and only the phase change applied to the pulse PB by the geophone 200 will be utilized in the digitizing operation. More particularly, the pulse PB propagates through a circuit including the geophone 200 which introduces a delay proportional to the displacement or velocity to be measured. The pulse PB is then compared to pulse PA circulating in the loop 210 by the phase comparator in the logic network 219. Through the use of the phase comparator, a discrete phase shifter and the control flipflop, there is encoded the rate of change of displacement, and therefore velocity, of the relative velocity of the elements comprising the geophone 200.

As a first step in the operation of the system shown in Fig. 5, a CLEAR signal having a *0* logic level and a time duration at least as long as one loop cycle is utilized to clear the loop by removing any preexisting pulses circulating within the loop. The CLEAR signal is applied to the CLR input of the one-shot multivibrator 211 and the flipflop 220 and to the PR input of the control flipflop included within the logic network 219. The Q output of the control flipflop is set to a *1* logic level and the Q output of the flipflop 220 is set to a *0* logic level. The PR or preset input of the control flipflop is similar to the CLR or clear input except that the application of a *0* signal to that input forces the Q output to a *1* and the $\overline{Q}$ output to a *0*. The use of the PR input to the control flipflop is the only variation between logic networks 19 and 219.

A START pulse generated from a source, not shown is applied to one input of the OR logic gate 221 and its leading edge propagates to the B input of the one-shot multivibrator 211 to excite the multivibrator and generate at its Q output the pulse PB. The pulse PB now circulates around the loop 210 by way of conductor 212, summing junction 213, and delay network 214 to the inverted input A of the multivibrator 211. The negative going or trailing edge of the pulse PB triggers the one-shot multivibrator 211 and the process continues with pulse PB circulating about the loop, thereby providing one of the two oscillators.

When pulse PB first appears at the Q output of the one-shot multivibrator 211, its leading edge clocks both the phase comparator and control flipflops. The effect of this is to initialize the control flipflop such that its Q output is a logic *0* and its $\overline{Q}$ output is a logic *1*. In Figs. 1 and 4 the pulse PA is started first. In Fig. 5 the pulse PB is started first and the logic network 218 is preset by the CLEAR signal. Thus, when PB first appears, the control flipflop changes states and places the logic network 219 in the same starting condition provided for logic network 19. Now, when pulses PA and PB circulate in the loop and are applied to the logic network 219, they will serve the same functions as the previously described pulses PA and PB when applied to logic network 19.

The pulse PA is generated for circulation in the loop 210 in response to the first appearance of the pulse PB at the Q output of the multivibrator 211. The pulse PB is applied to amplifier 222 and the amplified output excites the piezoelectric transmitter 205 to generate an acoustic wave or pulse 223. Upon arrival of the acoustic pulse, traveling by way of the air space within the case or casing 201, at the piezoelectric receiver 206, an electric signal or pulse is generated, amplified by the amplifier 224 and applied to the B input of a one-shot multivibrator 225. The multivibrator 225 is excited to regenerate pulse PB as a positive going pulse which propagates along conductors 226 and 227 to an input of the NOR logic gate 221 and appears at the B input of the one-shot multivibrator 211. The multivibrator 211 is excited now to generate at its Q input the pulse PA. The pulse PA now begins circulating in the loop 210 in a manner described in conjunction with the circulation of the pulse PB.

The pulse PB is also applied by way of conductor 226 to the CLK input of the flipflop 220. The flipflop will now change state to produce at its Q output a *1* logic level. With a *1* logic level applied to the D input of the flipflop 220, the flipflop 220 will be non-responsive to any further positive pulses applied to its clock input and will maintain at its Q output a logic *1* and thereby effectively and for all practical purposes gating shut the B input of the one-shot multivibrator 211. This arrangement pervents the one-shot multivibrator 211 from producing any pulses other than as a result of pulses being applied to its inverted input A.

The appearance of pulse PA at the Q output of the one-shot multivabrator 211 is effective to clock the phase comparator flipflop and the control flipflop within the logic network 219, and this will be the sole function of pulse PA, that is, to clock the phase comparator flipflop and the control flipflop each time the pulse appears at the Q output of the multvibrator 211. While the pulse PA propagates along a path that includes the amplifier 222, the transducers 205, 206, the amplifier 224 and appears again at the output of the one-shot multivibrator 225, its appearance at the Q output of the multivibrator 225 does not affect the D input of the phase comparator flipflop within the logic network 219. This is by reason of the fact that the NAND gate 230 within the logic network 219 is conditioned by the control flipflop $\overline{Q}$ output such that positive going pulse PA appearing on the conductor 226 is ineffective to change the output of the NAND gate 230. It will be recalled that the flipflop 220 has been conditioned such that further positive pulses applied to the CLK input will be ineffective to change the state of the flipflop, and therefore the pulse PA, and indeed future occurrences of the pulse PA at the CLK input of the flipflop 220, will be ineffective to change its state.

In the embodiment illustrated in Fig. 5, the reference point in the system for the pulse PA is the Q output of the one-shot multvibrator 211 and the reference pulse for the pulse PB is the Q output of the one-shot multivibrator 225. Under start conditions above-described, the pulses PA and PB appear at their respective reference points at approximately the same time, and therefore are viewed by the logic network 219 as being in phase while they propagate around the loop 210 in an out-of-phase relationship.

When the pulse PB is early with respect to pulse PA, that is, the pulse PB arrives at its reference point, the Q output of the multivibrator 225, before the pulse PA arrives at its reference point, the Q output of the multivibrator 211, a logic 1 will appear at the Q output of the phase comparator flipflop and a 0 logic level will appear at the Q̄ output of the same flipflop. The 0 logic level will be applied by way of impedance or resistor 231 to the summing junction 213, and the pulse PA will pass through the junction 213 without delay being applied to its trailing edge. Now when the pulse PR next appears at the Q output of the one-shot multivibrator 211, its leading and positive going edge will clock the phase comparator flipflop and cause it to change state. Thus, a logic 1 will now appear at the Q̄ output of the phase comparator flipflop and will propagate through the resistor 231 to the summing junction 213 where it will cause the trailing edge of the pulse PB to be delayed. When the pulse PB is late with respect to the pulse PA, that is, the pulse PA arrives at its reference point before the pulse PB arrives at its reference point, the reverse will hold true. PA will be delayed and pulse PB will not.

The delay introduced at the summing junction 213 is very small compared to the total loop time. For example, the delay may be of the order of 1 nanosecond while the loop time may be as high as 10 microseconds. The loop time or frequency is preferably chosen to be at least twice the highest frequency of its relative velocity between the mass 202 and the case 201 of the geophone 200.

The detail operation of the logic network 219 has not been described in order to reduce the length of the specification and avoid redundancy. The operation of the logic network 219 has already been described in the operation of the logic network 19 in conjunction with the embodiment of Fig. 1.

Each time the pulse PA appears at its reference point, a positive pulse is applied to an input of the logic NOR gate 232. The trailing edge of the pulse PA appears as a positive going edge at the output of the NOR gate 232 and is applied to the utilization means 240 as a strobe to indicate that the logic level appearing at the Q output of the phase comparator flipflop is valid and is to be utilized. The signal at the Q output of the phase comparator flipflop will have logic 1's proportional to the velocity of the mass 202 moving in an upward direction and logic 0's proportional to the velocity of the mass 202 moving in a downward direction. This digital pulse train is applied from the Q output of the phase comparator to an input of the utilization means and is indicative of the variations in velocity of the mass 202 relative to the casing or case 201. The utilization means may be a digital low-pass filter to generate a multiple bit binary word at a lower data rate. On the other hand, the pulse stream from the phase comparator flipflop Q output may be processed by an analog low-pass filter to construct an analog representation of the original variable.

The identical logic network 19 has been utilized in each of the embodiments of Figs. 1 and 4 and, with the exception noted above, has been repeated as logic network 219 in the embodiment of Fig. 5. The function of the logic network is to identify which of the pulses PA to PB is leading and upon such determination, to generate a logic 1 level or a logic 0 level selectively to apply a discrete phase or time delay to the leading pulse in order to bring the pulses to an in-phase relationship as seen by the logic network. With the function of the logic network 19 clearly in mind, it will be obvious to those skilled in the art that other logic networks may be utilized to effect the same function and accordingly, the invention may be carried out with logic networks of design and components other than that illustrated by the logic network 19.

Analog-to-digital convertor

Fig. 6 illustrates an analog-to-digital convertor 300 which utilizes the basic principles of the present invention in that two oscillators are present. It differs from the earlier described embodiments in that the two oscillators or two circulating pulses do not share the same electrical loop. The first oscillator 301 may be any one of a variety of oscillators which operate at a selected suitable frequency. A suitable frequency in the practice of the present invention, for example, might be chosen to be at least twice the frequency of the analog input voltage to be digitized in order to satisfy Nyquist's sampling theorem. For the purpose of the present description, the oscillator 301 produces a square wave output at a frequency of 10,000 Hertz. The output of the oscillator 301 is applied to the D input of a phase comparator flipflop 302.

A second oscillator 305 is comprised of a loop including ramp generator 306, voltage comparator 307, conductor 308, delay means 309 and 310, and digital selector 311. The second oscillator 305 operates as follows. A START pulse from a source not shown is applied by way of conductor 320 to an input of the ramp generator 306. When triggered by the START pulse, the ramp generator 306 produces a negative going ramp function 307 (Fig. 7) which is applied to the inverting input of voltage comparator 307. The ramp function decreases linearly from a voltage of +V to −V over a pre-designed period, for example, 44 microseconds. The ramp generator may be constructed with transistors or integrated circuits with techniques well known in the art. Assuming that 0 voltage is applied to the non-inverting input of the voltage comparator 307, the voltage comparator will initially have a 0 logic output until the ramp voltage decreases to a value less than 0 whereupon the output of the comparator will go to a 1 logic level. The transition from the 0 logic to the 1 logic level is utilized to trigger the delay means 309 and 310, whose negative pulse outputs are applied to the digital selector 311. The selector 311 selectively gates one of the negative pulses to trigger the ramp generator 306. So long as 0 signal is applied to the voltage comparator 307, a pulse effectively will circulate about or propagate through the loop 305 at a fixed frequency, thereby providing the function of the second oscillator.

The voltage to be digitized is Vin applied by way of conductor 315 to the non-inverting input of the voltage comparator 307. In as much as the ramp generator covers a range of +V to −V, the system will be capable of digitizing any varying analog voltage whose amplitudes lie within that range. Before being triggered by the START signal, the ramp generator 306 output is at +V which, being greater than Vin, causes the voltage comparator 307 to have a logical output at the 0 level. Upon being triggered by START, the ramp generator output voltage will begin to linearly decrease toward −V. When the ramp voltage becomes less than Vin, the output of the voltage comparator 307 will go to its logic 1 level, trigger the delay means 309 and 310, and also clock the phase comparator flipflop 302. The ramp output of the generator 306 will continue to the −V level at which time the output will rapidly return to +V and the output of the voltage comparator 307 will return to the 0 logic level. If the 10,000 Hertz square wave from the oscillator 301 is low at the time the phase comparator or encoder 302 is clocked, then a logical 0 will appear at the Q output of the phase comparator or encoder. On the other hand, if the clocking of the phase comparator or encoder 302 occurs when the square wave is at a high level, then a logic 1 will appear at the Q output of the comparator 302. The logic level at the Q output of the phase comparator 302 is utilized to control the operation of the digital selector 311. This operation is shown schematically by dashed line 321, figuratively connecting the logic levels from encoder 302 to the movable arm 322 of switch 323, signifying the switching operation of the digital selector. A logic level of 0 effectively moves the arm to connect with the output from one of the delay means, whereas a logic level of 1 causes the arm to move and connect with the output from the other delay means.

The delay means 309 generates a 52 microsecond negative pulse, and the delay means 310 generates a 105 microsecond negative pulse. These delays can be generated with one-shot multivibrator or with other techniques well known in the art. A 105 microsecond delay was chosen since it is slightly greater than the 100 microsecond period of the 10,000 Hertz oscillator while the 52 microsecond period was chosen since it is slightly greater than one-half of the 100 microsecond period. Similarly, the 44 microsecond ramp time for the generator 306 was selected because it is less than one-half of the 100 microsecond period. While the exact values of these times is not critical, the time relationships as between the various delays and the ramp function are related to the period of the signal generated by the oscillator 301.

The transition of the ramp voltage through the value of Vin and therefore the change in the voltage comparator output from the 0 logic level to the 1 logic level, is compared with the 10,000 Hertz square wave on each cycle. If the positive transition of the voltage comparator occurs before the positive transition of the square wave, then the phase comparator 302 will latch a 0 logic level at its Q output. This 0 logic level causes the digital selector 311 to gate the 105 microsecond pulse to the ramp generator 306 to cause a delay in the loop greater than the external oscillator period. If the positive transition of the voltage comparator occurs after the positive transition of the square wave, then the phase comparator 302 will latch a 1 logic level at its Q output. This 1 logic level causes the digital selector 311 to gate the 52 microsecond pulse to the ramp generator 306 to cause a delay in the loop less than the external oscillator period. The actual loop time on each cycle of the oscillator 305 will thus be either the time caused by the value of Vin+52 microseconds or the time caused by the value of Vin+105 microseconds with the addition of other minor circuit delays common to both cases. If the 52 microsecond delay is utilized, then the total delay will vary from 52 microseconds to 52+44 or 96 microseconds, depending upon the value of Vin. If the 105 microsecond delay is utilized, then the delay will vary from 105 microseconds to 105+44 or 149 microseconds, depending upon the value of Vin. The frequency of the oscillator 305 will remain at 10,000 Hertz, the same as the reference frequency from the oscillator 301, but its phase will vary by almost one-half cycle from the reference.

Each complete cycle or frame of the 10,000 Hertz square wave from oscillator 301 must be compared for valid results. The selection of the delays of the delay means 309 and 310 is such that the short delay of 52 microseconds will assure that the sampling will not skip the next occurring frame or cycle from the oscillator 301 while the longer delay of 105 microseconds will assure that the sampling will take place in the next succeeding frame.

The operation of the system of Fig. 6 is illustrated by the wave form timing diagram of Fig. 7, wherein the points Vin on the ramp generator output 307 are a locus of points depicting the analog voltage Vin. The variation of Vin would seem to be very slow moving. That is because the analog voltage Vin is shown on a very much expanded time scale.

At time $T_1$, the digital selector 311 output becomes positive going, triggering the ramp generator 307. The value of the ramp function is compared with the value of Vin. At time $T_2$ the value of the ramp function has fallen just below the sample value of the voltage Vin and the output of the voltage comparator 307 goes positive to clock the phase comparator 302 (Fig. 6). At that moment, the output of the oscillator 301 is at a logic $0$ and the output of the encoder or phase comparator 302 is a logic $0$. The digital selector 311 responds to the $0$ logic and applies the 105 microsecond delay to the input of the ramp generator. At time $T_3$ the output of the digital selector 311 goes positive and triggers the ramp generator 307 to produce another ramp function and to sample the value of the analog voltage Vin. The output of the voltage comparator 307 goes positive at time $T_4$ at which moment the value of the output of oscillator 301 is a logic $0$. As a result, the digital selector applies another long delay in response to the $0$ logic output of the encoder 302.

At time $T_5$ the output of the digital selector 311 again goes positive, triggering the ramp generator with the resultant sampling of the analog voltage Vin at time $T_6$. The output of the voltage comparator 307 again goes positive. At that moment, the output of the oscillator 301 is at a logic $1$ and the encoded output of the phase comparator 302 becomes a logic $1$ causing the digital selector 311 to select the shorter delay from the 52 microsecond delay means 309 (Fig. 6). Now at time $T_7$, the output of the digital selector 311 goes positive, triggering the ramp generator with the resultant sampling of the value of the analog voltage Vin occurring at time $T_8$. The output of the voltage comparator 307 goes positive, and the phase comparator has the logic $0$ level applied to its D input from the oscillator 301 to produce a logic $0$ at its output at time $T_8$.

The process continues with either a short delay or a long delay selected by the digital selector 311 in order that the logic level of the oscillator output be sampled at each and every frame of the oscillator output. The result is a single weighed digital function produced at the output of the encoder or phase comparator 302. Like the single weighed digital pulse output of the earlier described velocity digitizers, the output of the encoder or phase comparator 302 can be processed by a digital low-pass filter to generate a multi-bit binary word at a lower data rate or it can be processed by an analog low-pass filter to construct an analog representation of the original variable.

Now that the invention and a number of embodiments have been described, variations and modifications will become apparent to those skilled in the art. It is intended that such modifications and variations be encompassed within the scope of the appended claims.

**Claims**

1. The method of generating a digital signal representative of an analog value comprising the steps of:

a) generating with two generating means, each independent of the other, two highfrequency digital pulse signals, the frequencies of which are constant and harmonically related one to the other;

b) applying a sample of the analog value to at least one of said generating means to cause a shift in phase in at least one of the two highfrequency pulse signals;

c) comparing the said highfrequency digital pulse signals to obtain a measure signal of the phase shift;

d) utilizing the measure signal of the phase shift to adjust the phase of the said highfrequency digital pulse signals toward an in-phase condition; and

e) generating a further digital signal representative of the amplitude of the said measure signal utilized to return said highfrequency digital pulse signals toward the in-phase condition.

2. The method of claim 1 in which said analog value is applied to effect a shift in phase of both highfrequency digital pulse signals.

3. The method of claim 1 or 2 in which said measure signal of the phase shift is utilized to introduce a delay in the one of said phase shifted highfrequency digital pulse signals which is in advance of the other.

4. The method of claim 1 in which said measure signal of the phase shift is utilized to introduce a delay in the phase shifted highfrequency digital pulse signal to return said phase shifted highfrequency digital pulse signal toward an in-phase condition with the other signal.

5. The method of any one of claims 1 to 4 in which said two highfrequency digital pulse signals are generated by introducing two pulses at spaced points into a loop and introducing into said loop a sample of said analog value to effect a phase shift as between said highfrequency digital pulse signals.

6. The method of any one of claims 1 to 5 in which said digital signal is representative of the magnitude of a varying analog value.

7. The method of any one of claims 1 to 5 in which said digital signal is representative of the rate of change of a varying analog value.

8. The method of any one of claims 1 to 7 in which said digital signal is applied to a low-pass analog filter to produce an analog signal representative of said analog value.

9. The method of any one of claims 1 to 8 in which said digital signal is a single weighed digital signal.

10. An apparatus specifically designed for performing the method of generating a digital signal representative of an analog value according to any one of claims 1 to 9 comprising:

a) two means for generating highfrequency digital pulse signals whose frequencies are constant and harmonically related one to the other, each said generating means comprising an oscillator;

b) means (100) responsive to a sample of said analog value to affect a relative phase shift between said highfrequency digital pulse signals;

c) means (19) for measuring said relative phase shift and for obtaining a measure signal thereof;

d) means responsive to said measure signal to return said highfrequency digital pulse signals toward an in-phase relationship;

e) means for producing a further digital signal representative of said measure signal; and

f) means (134) for utilizing said digital signal.

11. The apparatus of claim 10 in which said measuring means (19) is a logic network including a phase comparator (21).

12. The apparatus of claims 10 or 11 in which said utilizing means (134) is means for converting said further signal to multi-bit binary words.

13. The apparatus of claim 12 in which said converting means is a low-pass digital filter.

14. The apparatus of any one of claims 10 to 13 in which said further digital signal is a single weighed digital signal.

15. The apparatus of claims 10 or 11 in which said utilizing means includes a low-pass analog filter and means for recording the output of said filter.

16. The apparatus of any one of claims 10 to 15 in which said analog value responsive means (100) effects a shift in phase of at least one of the oscillators.

17. The apparatus of claim 16 in which said means responsive to said measure signal introduces a delay in the one of said highfrequency digital pulse signals which is in advance of the other.

18. The apparatus of any one of claims 10 to 17 in which one of said oscillators has a fixed phase, constant pulse rate output, which is connected to one input of a phase comparator, the output of the other of said oscillators being connected to another input of said phase comparator.

19. The apparatus of any one of claims 10 to 18 in which said oscillators comprise a loop (305) including at least two parallel paths each including time-delay means (309, 310) in said loop (305).

20. The apparatus of any one of claims 10 to 19 in which said oscillators comprise a loop including two separated one shot multivibrators (115, 116), means for applying a start pulse simultaneously to both multivibrators (115, 116) to generate two pulses which circulate in said loop, and in which said means (100) responsive to a sample of said analog value is connected in said loop between said multivibrators (115, 116).

21. The apparatus of any one of claims 10 to 15 in which said oscillators comprise a loop (11) and means for introducing two pulses at spaced points in said loop after a signal representative of a sample of said analog value effects the phase relationship of said two pulses.

22. The apparatus of any one of claims 10 to 19 in which said oscillators comprise a loop (11), means for introducing two pulses at spaced points in said loop, and means for introducing between said loop (11) and said means (21) for measuring said relative phase shift a signal representative of said analog value to effect a phase shift in at least one of said highfrequency digital pulse signals.

23. The apparatus according to any one of claims 19 to 22 in which said loop includes a summing junction (118) at which a delay signal is applied to the first arriving pulse.

24. The apparatus according to claim 23 in which said delay signal is a voltage which modifies a characteristic of one of the edges of the first arriving pulse.

25. The apparatus of any one of claims 10 to 21 in which one of said oscillators produces a constant frequency, constant phase highfrequency digital pulse signal and the other of said oscillators comprises a loop generating a second highfrequency digital pulse signal, and means (200) for introducing in said loop a signal representative of said analog value to effect a phase shift in said second highfrequency digital pulse signal.

26. The apparatus according to any one of claims 10 to 25 in which said means (100) responsive to a sample of said analog value comprises a housing (101), a mass of fixed dimensions, said housing (101) and said mass being movable relative to one another in response to said analog value, an input (105, 108) for receiving digital pulses, means (106, 107) within said housing (101) responsive to the appearance of said digital pulses at said input for introducing a phase shift in said digital signals proportional to the relative positions between said housing and said mass.

27. The apparatus according to claim 26 in which said means (105 to 108) within said housing (101) are circuit elements, one of said elements (105, 108) being mounted on an inner surface of said housing (101) and another of said elements (106, 107) being mounted on said mass whereby the phase shift is introduced by relative movement between said elements.

28. The apparatus according to claim 26 or 27 in which said means (100) reponsive to said analog value is responsive to acoustic energy, especially acoustic energy as represented by movements of the earth.

29. The apparatus according to claims 27 and 28 wherein said means (100) responsive to said analog value is a geophone and said circuit elements (105 to 108) are transducers, one of said transducers (105, 108) being a transmitter and the other of said transducers being a receiver.

30. The apparatus according to claim 29 in which said transducers (105 to 108) are acoustic transducers.

31. The apparatus according to claim 30 in which said acoustic transducers (105 to 108) are piezoelectric devices.

32. The apparatus according to any one of claims 27 to 31 in which said digital pulses have an occurrence rate in the order of 100 kHz.

33. The apparatus according to any one of claims 29 to 32 in which a second transducer element (107) is mounted on an opposite face of said spring mounted element and a second mating transducer (108) is mounted on an inner surface of said housing (101) opposite said second transducer element (107) to form a second transducer assembly, said first and second transducer assemblies each introducing a different phase shift in one of said two digital signals.

**Patentansprüche**

1. Verfahren zur Erzeugung eines digitalen Signales, das einen Analogwert darstellt, mit folgenden Schritten:
a) Erzeugung von zwei Hochfrequenz-Digital-Puls-Signalen deren Frequenzen konstant und harmonisch aufeinander bezogen sind mit zwei Erzeugungseinrichtungen, die jeweils unabhängig voneinander sind;
b) Anlegen einer Probe des Analogwertes an mindestens eine der Erzeugungseinrichtungen um einen Phasenversatz mindestens eines der zwei Hochfrequenz-Digital-Puls-Signals zu erzeugen;
c) Vergleichen der Hochfrequenz-Digital-Pols-Signals um ein Meßsignal des Phasenversatzes zu erhalten;
d) Verwertung des Meßsignales des Phasenversatzes zur Anpassung der Phase der Hochfrequenz-Digital-Puls-Signals an einen in-Phasen-Zustand; und
e) Erzeugung eines weiteren digitalen Signales, das die Amplitude des Meßsignales darstellt, um die Hochfrequenz-Digital-Puls-Signals in den in-Phasen-Zustand zurückzuversetzen.

2. Verfahren nach Anspruch 1, bei dem der Analogwert angelegt wird, um einen Phasenversatz von beiden Hochfrequenz-Digital-Puls-Signalen zu bewirken.

3. Verfahren nach Anspruch 1 oder 2, bei dem das Meßsignal das Phasenversatzes verwertet wird, um eine Verzögerung in einem der beiden phasenversetzten Hochfrequenz-Digital-Puls-Signale, welches einen Zeitvorsprung vor dem anderen hat, einzuführen.

4. Verfahren nach Anspruch 1, bei dem das Meßsignal des Phasenversatzes verwertet wird, um eine Verzögerung in das phasenversetzte Hochfrequenz-Digital-Puls-Signal einzuführen, um das phasenversetzte Hochfrequenz-Digital-Puls-Signal in einen in-Phase-Zustand mit dem anderen Signal zurückzuversetzen.

5. Verfahren nach einem der Ansprüche 1 bis 4, bei dem die zwei Hochfrequenz-Digtital-Puls-Signale dadurch erzeugt werden, daß zwei Pulse an getrennten Punkten in eine Schleife eingeführt werden und in diese Schleife eine Probe des Analogwertes eingeführt wird, um einen PHasenversatz wie zwischen den Hochfrequenz-Digital-Puls-Signalen zu erzeugen.

6. Verfahren nach einem der Ansprüche 1 bis 5, bei dem das Digitalsignal die Größe eines variierenden Analogwertes darstellt.

7. Verfahren nach einem der Ansprüche 1 bis 5, bei dem das Digitalsignal die Änderungsrate eines variierenden Analogwertes darstellt.

8. Verfahren nach einem der Ansprüche 1 bis 7, bei dem das Digitalsignal an ein Tiefpaß-Analog-Filter angelegt wird, um ein analoges Signal zu erzeugen, das den Analogwert darstellt.

9. Verfahren nach einem der Ansprüche 1 bis 8, bei dem das Digitalsignal ein einfach gewichtetes Digitalsignal ist.

10. Vorrichtung, die zur Durchführung des Verfahrens zur Erzeugung eines Digitalsignales besonders ausgebildet ist, das einen Analogwert darstellt, nach einem der Ansprüche 1 bis 9 mit:
a) zwei Einrichtungen zur Erzeugung von Hochfrequenz-Digital-Puls-Signalen, deren Frequenzen konstant und harmonisch aufeinander bezogen sind, wobei jede der beiden Erzeugungseinrichtungen einen Oszillator aufweist;
b) einer Einrichtung (100), die auf eine Probe des Analogwertes anspricht, um einen relativen Phasenversatz zwischen den Hochfrequenz-Digital-Puls-Signalen zu bewirken;
c) einer Einrichtung (19) zum Messen das relativen Phasenversatzes und um ein Meßsignal davon zu erhalten;
d) einer Einrichtung, die auf das Meßsignal anspricht, um die Hochfrequenz-Digital-Puls-Signale in eine in-Phasen-Beziehung zurückzuversetzen;
e) einer Einrichtung zur Erzeugung eines weiteren Digitalsignales, welches das Meßsignal darstellt; und
f) einer Einrichtung (134) zur Verwertung des Digitalsignales.

11. Vorrichtung nach Anspruch 10, bei der die Meßeinrichtung (19) aus einem logischen Netzwerk mit einem Phasenkomparator (21) besteht.

12. Vorrichtung nach Anspruch 10 oder 11, bei der die Verwertungseinrichtung (134) eine Einrichtung zur Konvertierung des weiteren Signales in Multi-Bit-Binärworte ist.

13. Vorrichtung nach Anspruch 12, bei der die Konvertierungseinrichtung ein Tief-Paß-Digital-Filter ist.

14. Vorrichtung nach einem der Ansprüche 10 bis 13, bei der das weitere Digitalsignal ein einfach gewichtetes Digitalsignal ist.

15. Vorrichtung nach Anspruch 10 oder 11, bei der die Verwertungseinrichtung ein Tief-Paß--Analog-Filter sowie eine Einrichtung zum Aufzeichnen des Outputs aus dem Filter enthält.

16. Vorrichtung nach einem der Ansprüche 10 bis 15, bei der die auf den Analogwert ansprechende Einrichtung (100) einen Phasenversatz bei mindestens einem der Oszillatoren bewirkt.

17. Vorrichtung nach Anspruch 16, bei der die Einrichtung, die auf das Meßsignal anspricht, eine Verzögerung bei einem der beiden Hochfrequenz-Digital-Puls-Signale, welches einen Zeitvorsprung vor dem anderen hat, einführt.

18. Vorrichtung nach einem der Ansprüche 10 bis 17, bei der einer der Oszillatoren einen phasenfesten konstanten Pulsratenausgang hat, der mit einem Eingang eines Phasenkomparators verbunden ist, wobei der Ausgang des anderen Oszillators mit einem anderen Eingang des Phasenkomparators verbunden ist.

19. Vorrichtung nach einem der Ansprüche 10 bis 18, bei der die Oszillatoren eine Schleife (305) mit mindestens zwei parallelen Pfaden, von denen jeder eine Zeit-Versatzeinrichtung (309, 310) in besagter Schleife (305) enthält aufweisen.

20. Vorrichtung nach einem der Ansprüche 10 bis 19, bei der die Oszillatoren eine Schleife mit zwei getrennten EinSchuß-Multivibratoren (115, 116), eine Einrichtung zum Anlegen eines Startpulses simultan zu beiden Multivibratoren (115, 116) zur Erzeugung zweier Pulse, die in der Schleife zirkulieren, und mit der die Einrichtung (100), die auf eine Probe des Analogwertes anspricht, in besagter Schleife zwischen den Multivibratoren (115, 116) verbunden ist, aufweisen.

21. Vorrichtung nach einem der Ansprüche 10 bis 15, bei der die Oszillatoren eine Schleife (11) sowie eine Einrichtung zur Einführung von zwei Pulsen an getrennten Punkten in der Schleife aufweisen, nachdem ein Signal, das eine Probe des Analogwertes darstellt, die Phasenbeziehung der zwei Pulse bewirkt.

22. Vorrichtung nach einem der Ansprüche 10 bis 19, bei der die Oszillatoren eine Schleife (11), eine Einrichtung zum Einführen von zwei Pulsen an getrennten Punkten in der Schleife, und eine Einrichtung enthalten, die zwischen der Schleife (11) und der Einrichtung (21) zum Messen des relativen Phasenversetzes ein Signal einführt, das den Analogwert darstellt, um einen Phasenversatz mindestens eines der beiden Hochfrequenz-Digital-Puls-Signale zu bewirken.

23. Vorrichtung nach einem der Ansprüche 19 bis 22, bei der die Schleife eine summierende Station (118) enthält, an der ein Verzögerungssignal an den ersten ankommenden Puls angelegt wird.

24. Vorrichtung nach Anspruch 23, bei der das Verzögerungssignal eine Spannung ist, die die Charakteristik von einer der Flanken des ersten ankommenden Pulses modifiziert.

25. Vorrichtung nach einem der Ansprüche 10 bis 21, bei der einer der Oszillatoren ein frequenzkonstantes, phasenkonstantes Hochfrequenz-Digital-Puls-Signal erzeugt und der andere der beiden Oszillatoren eine Schleife enthält, die ein zweites Hochfrequenz-Digital-Puls-Signal erzeugt, sowie eine Einrichtung (200) zur Einführung eines Signales, das den Analogwert darstellt, in die Schleife, um einen Phasenversatz im zweiten Hochfrequenz-Digital-Puls-Signal zu bewirken.

26. Vorrichtung nach einem der Ansprüche 10 bis 25, bei der die Einrichtung (100), die auf eine Probe des Analogwertes anspricht, ein Gehäuse (101), und eine Masse von festen Dimensionen umfaßt, wobei das Gehäuse (101) und die Masse als Antwort auf den Analogwert relativ zu einander beweglich sind sowie einen Eingang (105, 108) für den Empfang von Digital-Pulsen und eine Einrichtung (106, 107) im Gehäuse (101), die auf das Erscheinen der Digital-Pulse am Eingang anspricht, für die Einführung eines Phasenversatzes bei den Digitalsignales proportional zu den relativen Positionen zwischen dem Gehäuse und der Masse.

27. Vorrichtung nach Anspruch 26, bei der die Einrichtungen (105 bis 108) im Gehäuse (101) Schaltkreiselemente sind, wobei eines der Elemente (105, 108) an einer inneren Oberfläche des Gehäuses (101) befestigt ist und ein anderes der Elemente (106, 107) an der Masse befestigt ist, wobei der Phasenversatz durch relative Bewegung zwischen den Elementen eingeführt wird.

28. Vorrichtung nach Anspruch 26 oder 27, bei der die Einrichtung (100), die auf den Analogwert anspricht, auf akustische Energie, speziell auf akustische Energie, wie sie bei Bewegungen der Erde vorkommt, anspricht.

29. Vorrichtung nach den Ansprüchen 27 und 28, bei der die Einrichtung (100), die auf den Analogwert anspricht, ein Geophon ist und bei der die Schaltkreiselemente (105 bis 108) Wandler sind, wobei einer der Wandler (105, 108) ein Sander und der andere Wandler ein Empfänger ist.

30. Vorrichtung nach Anspruch 29, bei der die Wandler (105 bis 108) akustische Wandler sind.

31. Vorrichtung nach Anspruch 30, bei der die akustischen Wandler (105 bis 108) piezoelektrische Geräte sind.

32. Vorrichtung nach einem der Ansprüche 27 bis 31, bei der die Digitalpulse eine Auftrittsrate in der Größenordnung von 100 kHz haben.

33. Vorrichtung nach einem der Ansprüche 29 bis 32, bei der ein zweites Wandlerelement (107) auf einer gegenüberliegenden Fläche des federnd befestigten Elementes befestigt ist, und ein zweiter passender Wandler (108) auf einer inneren Oberfläche des Gehäuses (101) gegenüber dem zweiten Wandlerelement (107) befestigt ist, um einen zweiten Wandleraufbau zu bilden, wobei der erste und der zweite Wandleraufbau jeweils einen unterschiedlichen Phasenversatz bei einem der beiden Digitalsignale einführen.

**Revendications**

1. Procédé pour engendrer un signal numérique représentatif d'une valeur analogique, comprenant les étapes suivantes:

a) On engendre grâce à deux moyens générateurs, dont chacun est indépendant de l'autre, deux signaux d'impulsions numériques à haute fréquence dont les fréquences sont constantes et en relation harmonique l'une avec l'autre;

b) On applique un échantillon de la valeur analogique à l'un au moins desdits moyens générateurs pour produire un décalage de phase dans l'un au moins des deux signaux d'impulsions à haute fréquence;

c) On compare lesdits signaux d'impulsions numériques à haute fréquence pour obtenir un signal de mesure du déphasage;

d) On utilise le signal de mesure du déphasage pour régler la phase desdits signaux d'impulsions numériques à haute fréquence sur un état où ils sont en phase; et:

e) On engendre un autre signal numérique représentatif de l'amplitude dudit signal de mesure utilisé pour faire revenir lesdits signaux d'impulsions numériques à haute fréquence vers l'état où ils sont en phase.

2. Procédé selon la revendication 1, dans lequel ladite valeur analogique est appliquée pour produire un décalage de phase des deux signaux d'impulsions numériques à haute fréquence.

3. Procédé selon la revendication 1 ou 2, dans lequel ledit signal de mesure du déphasage est utilisé pour introduire un retard dans celui desdits signaux d'impulsions numériques à haute fréquence déphasés qui est en avance sur l'autre.

4. Procédé selon la revendication 1, dans lequel ledit signal de mesure du déphasage est utilisé pour introduire un retard dans le signal d'impulsions numériques à haute fréquence déphase pour remener ledit signal d'impulsions numériques à haute fréquence déphasé vers un état où il est en phase avec l'autre signal.

5. Procédé selon l'une quelconque des revendications 1 à 4, dans lequel lesdits deux signaux d'impulsions numériques à haute fréquence sont engendrés en introduisant deux impulsions dans une boucle en des points espacés, et en introduisant dans ladite boucle un échantillon de ladite valeur analogique pour réaliser un déphasage comme entre lesdits signaux d'impulsions numériques à haute fréquence.

6. Procédé selon l'une quelconque des revendications 1 à 5, dans lequel ledit signal numérique est représentatif de l'amplitude d'une valeur analogique variable.

7. Procédé selon l'une quelconque des revendications 1 à 5, dans lequel ledit signal numérique est représentatif de la vitesse de variation d'une valeur analogique variable.

8. Procédé selon l'une quelconque des revendications 1 à 7, dans lequel ledit signal numérique est appliqué à un filtre passe-bas analogique pour produire un signal analogique représentatif de ladite valeur analogique.

9. Procédé selon l'une quelconque des revendications 1 à 8, dans lequel ledit signal numérique est un signal numérique à simple pesée.

10. Appareil spécifiquement conçu pour mettre en oeuvre le procédé pour engendrer un signal numérique représentatif d'une valeur analogique selon l'une quelconque des revendications 1 à 9, comprenant:

a) Deux moyens pour angendrer des signaux d'impulsions numériques à haute fréquence dont les fréquences sont constantes et qui sont en relation harmonique l'une avec l'autre, chacun desdits moyens générateurs comprenant un oscillateur;

b) Des moyens (100) répondant à un échantillon de ladite valeur analogique pour produire un déphasage relatif entre lesdits signaux d'impulsions numériques à haute fréquence;

c) Des moyens (19) pour mesurer ledit déphasage relatif et pour obtenir un signal de mesure à partir de cela;

d) Des moyens répondant audit signal de mesure pour ramener lesdits signaux d'impulsions numériques à haute fréquence vers un état où ils sont en phase;

e) Des moyens pour produire un autre signal numérique représentatif dudit signal de mesure; et

f) Des moyens (134) pour utiliser ledit signal numérique.

11. Appareil selon la revendication 10, dans lequel lesdits moyens de mesure (10) sont un circuit logique comprenant un comparateur de phase (21).

12. Appareil selon la revendication 10 ou 11, dans lequel lesdits moyens d'utilisation (134) sont des moyens pour convertir ledit autre signal en des mots binaires à bits multiples.

13. Appareil selon la revendication 12, dans lequel lesdits moyens convertisseurs sont un filtre numérique passe-bas.

14. Appareil selon l'une quelconque des revendications 10 à 13, dans lequel ledit autre signal numérique est un signal numérique à simple pesée.

15. Appareil selon la revendication 10 ou 11, dans lequel lesdits moyens d'utilisation comprenant un filtre analogique passe-bas et des moyens pour enregistrer la sortie dudit filtre.

18. Appareil selon l'une quelconque des revendications 10 à 15, dans lequel lesdits moyens répondant à la valeur analogique (100) produisent un décalage de la phase de l'un au moins des oscillateurs.

17. Appareil selon la revendication 16, dans lequel lesdits moyens répondant audit signal de mesure introduisant un retard dans celui desdits signaux d'impulsions numériques à haute fréquence qui est en avance sur l'autre.

18. Appareil selon l'une quelconque des revendications 10 à 17, dans lequel l'un desdits oscillateurs comporte une sortie à phase fixe et à taux d'impulsions constant qui est reliée à une entrée d'un comparateur de phase, la sortie de l'autre desdits oscillateurs étant reliée à une autre entrés dudit comparateur de phase.

19. Appareil selon l'une quelconque des revendications 10 à 18, dans lequel lesdits oscillateurs comprennent une boucle (305) incluant au moins deux trajets parallèles dont chacun comprend des moyens de temporisation (309, 310) dans ladite boucle (306).

20. Appareil selon l'une quelconque des revendications 10 à 19, dans lequel lesdits oscillateurs comprennent une boucle incluant deux multivibrateurs monostables séparés (115, 116), des moyens pour appliquer une impulsion de départ simultanément aux deux multivibrateurs (115, 116) pour angendrer deux impulsions qui circulent dans ladite boucle, et dans lequel lesdits moyens (100) répondant à un échantillon de ladite valeur analogique sont montés dans ladite boucle entre lesdits multivibrateurs (115, 116).

21. Appareil selon l'une quelconque des revendications 10 à 15, dans lequel lesdits oscillateurs comprennent une boucle (11) et des moyens pour introduire deux impulsions en des points espacés de ladite boucle après qu'un signal représentatif d'un échantillon de ladite valeur analogique à réalisé la mise en phase desdites deux impulsions.

22. Appareil selon l'une quelconque des revendications 10 à 19, dans lequel lesdits oscillateurs comprennent une boucle (11), des moyens pour introduire deux impulsions en des points espacés de ladite boucle, et des moyens pour introduire, entre ladite boucle (11) et lesdits moyens (21) pour mesurer ledit déphasage relatif, un signal représentatif de ladite valeur analogique pour réaliser un déphasage dans l'un au moins desdits signaux d'impulsions numériques à haute fréquence.

23. Appareil selon l'une quelconque des revendications 19 à 22, dans lequel ladite bouclé comprend une jonction d'addition (118) où un signal de retard est appliqué à la première impulsion qui arrive.

24. Appareil selon la revendication 23, dans lequel ledit signal de retard est une tension qui modifie une caractéristique de l'un des fronts de la première impulsion qui arrive.

25. Appareil selon l'une quelconque des revendications 10 à 21, dans lequel l'un desdits oscillateurs produit un signal d'impulsions numériques à haute fréquence, à fréquence constante et à phase constante, et l'autre desdits oscillateurs comprend une boucle engendrant un second signal d'impulsions numériques à haute fréquence, et des moyens (200) pour introduire dans ladite boucle un signal représentatif de ladite valeur analogique pour produire un déphasage dans ledit second signal d'impulsions numériques à haute fréquence.

26. Appareil selon l'une quelconque des revendications 10 à 25, dans lequel lesdits moyens (100) répondant à un échantillon de ladite valeur analogique comprennent un logement (101), une masse de dimensions fixes, ledit logement (101) et ladite masse pouvant se déplacer l'un par rapport à l'autre en réponse à ladite valeur analogique, des entrée (105, 108) pour recevoir des impulsions numériques, et des moyens (106, 107) à l'intérieur dudit logement (101) qui répondent à l'apparition desdits impulsions numériques sur ladite entrée pour introduire dans lesdits signaux numériques un déphasage proportionnel aux positions relatives dudit logement et de ladite masse.

27. Appareil selon la revendication 26, dans lequel lesdits moyens (105 à 108) à l'intérieur dudit logement (101) sont des éléments de circuit, l'un desdits éléments (105, 108) étant monté sur une surface intérieure dudit logement (101), et l'autre desdits éléments (106, 107) étant monté sur ladite, masse, cependant que le déphasage est introduit par le mouvement relatif desdits éléments.

28. Appareil selon la revendication 26 ou 27, dans lequel lesdits moyens (100) qui répondent à ladite valeur analogique répondent à une énergie acoustique, en particulier à l'énergie acoustique représentée par des mouvements sismiques.

29. Appareil selon les revendications 27 et 28, dans lequel lesdits moyens (100) qui répondent à ladite valeur analogique sont un geophone, et lesdits éléments de circuit (105 à 108) sont des transducteurs, l'un (105, 108) desdits transducteurs étant un émetteur et l'autre desdits transducteurs étant un récepteur.

30. Appareil selon la revendication 29, dans lequel lesdits transducteurs (105 à 108) sont des transducteurs acoustiques.

31. Appareil selon la revendication 30, dans lequel lesdits transducteurs (105 à 108) sont des dispositifs piézo-électriques.

32. Appareil selon l'une quelconque des revendications 27 à 31, dans lequel lesdites impulsions numériques ont une fréquence d'apparition de l'ordre de 100 kHz.

33. Appareil selon l'une quelconque des revendications 29 à 32, dans lequel un second élément transducteur (107) est monté sur un côté opposé dudit élément monté sur ressort et un second transducteur d'accouplement (108) est monté sur une surface intérieure dudit logment (101) en face dudit deuxième élément transducteur (107) pour former un second montage transducteur, lesdits premier et second montages transducteurs introduisant chacun un déphasage différent dans l'un des deux signaux digitaux.

*FIG. 1*

## PB LATE

PAl6 ⎧1⎫
      ⎩0⎭

PBl6

PBl7

PAl7

Q̄23

Q̄22

### FIG. 1A

## PA LATE

PAl6

PBl6

PBl7

PAl7

Q̄23

Q̄22

### FIG. 1B

VOLTS

5

V3
V2

V1

0

T1          T2 T3

TIME

### FIG. 3

TRAILING EDGE OF PULSE AT SUMMING JUNCTION - 24

FIG. 2A

FIG. 2B

FIG. 4

EP 0 184 585 B1

FIG. 5

EP 0 184 585 B1

## FIG. 7

RAMP GENERATOR 306 OUT
+V
−V

VOLTAGE COMPARATOR 307 OUT

OSC 301 10KHz SQUARE WAVE

DIGITAL SELECTOR 311 OUT

ENCODER 302 OUT

T1 T2    T3 T4    T5 T6 T7 T8

## FIG. 6

OSC — 301

D  PHASE COMPARATOR FLIP-FLOP  Q — 302
CLK

300

321 — ENCODED OUTPUT

52 μSEC DELAY — 309

105 μSEC DELAY — 310

308

DIGITAL SELECTOR — 311
322
323

305

START — 320

44 μSEC RAMP GENERATOR — 306

+V
−V
44 μSEC

$V_{IN}$
315

VOLTAGE COMPARATOR — 307
+
−

9